(19) Europäisches Patentamt
European Patent Office
Office européen des brevets

(11) **EP 4 002 698 A1**

(12) **DEMANDE DE BREVET EUROPEEN**

(43) Date de publication:
**25.05.2022 Bulletin 2022/21**

(21) Numéro de dépôt: **21209011.2**

(22) Date de dépôt: **18.11.2021**

(51) Classification Internationale des Brevets (IPC):
**H03L 7/24** *(2006.01)* **G06N 3/06** *(2006.01)*

(52) Classification Coopérative des Brevets (CPC):
**H03L 7/24; G06N 3/06**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **24.11.2020 FR 2012054**

(71) Demandeur: **Commissariat à l'Energie Atomique et aux Energies Alternatives**
**75015 Paris (FR)**

(72) Inventeurs:
• **BADETS, Franck**
  **38054 GRENOBLE (FR)**
• **CASANOVA, Jean-Baptiste**
  **38054 GRENOBLE (FR)**

(74) Mandataire: **Marks & Clerk France**
**Immeuble "Visium"**
**22, avenue Aristide Briand**
**94117 Arcueil Cedex (FR)**

(54) **CIRCUIT SOMMATEUR DE PHASES À MULTI-INJECTIONS**

(57) Circuit sommateur de phases à multi-injections comprenant un oscillateur (300) ayant une fréquence d'oscillation propre F0, un circuit d'interface d'injection de référence (701) commandé par un signal de synchronisation de référence à une fréquence de référence et au moins un circuit d'interface d'injection additionnel (702,703) commandé par un signal de synchronisation secondaire à la fréquence de référence, chaque circuit d'interface d'injection (701,702,703) ayant un paramètre d'injection variable, les signaux de synchronisation secondaires étant chacun déphasés par rapport au signal de synchronisation de référence, l'oscillateur (300) étant configuré pour générer un signal de sortie à la fréquence de référence et déphasé par rapport au signal de synchronisation de référence d'un déphasage fonction d'une somme des déphasages respectifs de chaque signal de synchronisation secondaire par rapport au signal de synchronisation de référence, pondérée par les paramètres d'injection.

Fig. 7

EP 4 002 698 A1

**Description**

L'invention concerne le domaine des circuits de calcul pour réaliser des sommes pondérées, en particulier pour le domaine des réseaux de neurones artificiels.

Dans les applications nécessitant des algorithmes très consommateurs d'opérations mathématiques, telles que les applications d'intelligence artificielle et en particulier celles mettant en œuvre des réseaux de neurones artificiels, les fonctions les plus complexes sont généralement réalisées dans un serveur distant, par exemple dans un serveur cloud. De tels serveurs physiques ou virtuels ont une puissance de calcul élevée ce qui permet d'implémenter les algorithmes les plus couteux en opérations de façon déportée.

Cependant, cette solution présente des inconvénients en termes d'encombrement des communications (bande passante disponible pour accéder au serveur), de sécurité des données et de latence induite par l'accès à distance au serveur.

Il y a donc un intérêt à pouvoir réaliser ces calculs dans des circuits proches des capteurs qui génèrent les données à traiter afin de limiter les connexions au serveur cloud.

Pour cela, il est nécessaire de réduire la consommation et la surface occupée par le circuit réalisant l'algorithme de base, par exemple la fonction d'un neurone artificiel.

Dans le domaine des implémentations de réseaux de neurones artificiels, différentes architectures analogiques ou mixte sont décrites dans la littérature.

Une première solution, décrite dans le document [1] vise à réaliser un neurone formel dans le domaine analogique/mixte en réalisant une somme pondérée au moyen d'un convertisseur numérique analogique à redistribution de charges. Afin de simplifier les opérations de multiplication, les entrées ne peuvent prendre que trois valeurs 1,-1,0. Un comparateur analogique est utilisé pour fournir le résultat du calcul. Une meilleure consommation et une plus faible surface sont obtenues par rapport aux implémentations numériques. Néanmoins, l'utilisation de blocs analogiques et mixtes (convertisseur DAC et comparateur) induisent une sensibilité aux variations PVT (process voltage et température). D'autre part, la présence de convertisseurs DACs est pénalisante pour la surface d'un neurone.

Une deuxième solution décrite dans [2] concerne les réseaux de neurones impulsionnels, pour lesquels l'information est transmise par une variation d'une densité d'impulsion en sortie du neurone. En particulier, la solution décrite dans ce document remplace les convertisseurs analogiques numériques en courant qui sont utilisés pour mémoriser le poids des synapses par des mémoires RRAMs ce qui permet d'obtenir une bonne densité d'intégration. La consommation de la solution bénéficie de l'implémentation analogique du neurone mais aussi du comportement asynchrone du neurone. Néanmoins, le design analogique rend le circuit sensible aux variabilités du procédé de fabrication, de la tension d'alimentation et de la température.

Une troisième solution décrite dans [3] vise à réaliser des réseaux d'apprentissage à oscillateurs couplés. A la différence de la solution objet de la présente invention, la sortie du réseau est lue dans le domaine des fréquences des oscillateurs et non dans le domaine des phases. Ces solutions peuvent être basées sur des oscillateurs nanomagnétiques. L'avantage de ces oscillateurs est leurs dimensions nanométriques permettant d'envisager une très forte densité d'intégration. D'autre part ces oscillateurs ont de très hautes fréquences ce qui permet d'envisager une très bonne efficacité énergétique. Cependant, la lecture dans le domaine fréquentiel est plus difficile et demande des circuits auxiliaires de détection de verrouillage. D'autre part les signaux de sortie sont de l'ordre du mV et sont difficiles à exploiter sans amplification.

Une quatrième solution décrite dans [4] concerne les réseaux de neurones oscillatoires basés sur des circuits de boucle à verrouillage de phase. Le principal avantage de ces architectures est une meilleure robustesse aux variations PVT provenant du fait que l'information est contenue dans une mesure de phase différentielle entre les neurones de sortie. Cependant, l'utilisation d'un circuit de boucle à verrouillage de phase par neurone est très pénalisante en termes de surface de par la présence d'un filtre de boucle passif pour chaque neurone.

On connait par ailleurs les oscillateurs verrouillés par injection qui sont, par exemple, décrits dans les demandes de brevet FR1660100 et FR1872714.

L'invention propose un circuit sommateur dans le domaine des phases qui est notamment utilisable pour réaliser un réseau de neurones à oscillations. Le circuit selon l'invention est basé sur un oscillateur verrouillé par plusieurs circuits d'interface d'injection qui sont commandés par des signaux de synchronisation à la même fréquence mais déphasés entre eux. Les déphasages permettent de coder les signaux d'entrée et de sortie du neurone. Les poids synaptiques sont réglés par les amplitudes des courants d'injection ou des impédances de charge de chaque circuit d'interface d'injection. Dans la description suivante, on entend par « paramètre d'injection » l'un parmi ces deux paramètres : le courant d'injection ou l'impédance de charge d'un circuit d'interface d'injection.

L'invention présente notamment l'avantage d'un codage de l'information dans le domaine des phases qui permet de diminuer fortement la tension d'alimentation et donc la puissance consommée par le circuit comparé aux solutions analogiques-mixtes.

Par ailleurs la solution proposée présente un optimum de surface par rapport aux solutions basées sur des boucles à verrouillage de phase car elle ne nécessite qu'un seul oscillateur de base.

L'information codée dans le domaine des phases est plus facilement exploitable qu'une information codée dans le domaine fréquentiel.

L'information est en pratique codée par des différences de phase par rapport à un signal de référence ce qui rend les mesures moins sensibles aux variations PVT.

L'invention est applicable au domaine des réseaux de neurones mais plus généralement à tout circuit qui nécessite de réaliser une somme pondérée de signaux. Par exemple, l'invention permet de réaliser un intégrateur de phases.

L'invention a pour objet un circuit sommateur de phases à multi-injections comprenant un oscillateur ayant une fréquence d'oscillation propre F0, un circuit d'interface d'injection de référence commandé par un signal de synchronisation de référence à une fréquence de référence et au moins un circuit d'interface d'injection additionnel commandé par un signal de synchronisation secondaire à la fréquence de référence, chaque circuit d'interface d'injection ayant un paramètre d'injection variable, les signaux de synchronisation secondaires étant chacun déphasés par rapport au signal de synchronisation de référence, l'oscillateur étant configuré pour générer un signal de sortie à la fréquence de référence et déphasé par rapport au signal de synchronisation de référence d'un déphasage fonction d'une somme des déphasages respectifs de chaque signal de synchronisation secondaire par rapport au signal de synchronisation de référence, pondérée par les paramètres d'injection.

Dans une variante de réalisation, le circuit sommateur de phases selon l'invention comprend en outre un convertisseur de données en phases pour commander les déphasages respectifs des signaux de synchronisation secondaires par rapport au signal de synchronisation de référence.

Selon un aspect particulier de l'invention, lequel l'oscillateur est un oscillateur à relaxation.

Selon un aspect particulier de l'invention, le paramètre d'injection est un courant d'injection et chaque circuit d'interface d'injection est configuré pour injecter, en entrée de l'oscillateur, le courant d'injection de façon synchrone avec le signal de synchronisation qui le commande.

Selon un aspect particulier de l'invention, l'oscillateur comprend des premier et deuxième condensateurs agencés pour être respectivement dans deux états opposés parmi un état de charge et un état de décharge, chaque condensateur basculant de l'état de décharge vers l'état de charge en étant chargé par une source de courant interne à l'oscillateur.

Selon un aspect particulier de l'invention, l'oscillateur comprend des premier et deuxième transistors de charge et une bascule ayant une première sortie de donnée couplée à la grille du premier transistor et une seconde sortie de donnée, complémentée à la première sortie, couplée à la grille du second transistor, la bascule ayant en outre une entrée de synchronisation couplée au premier condensateur et une entrée de réinitialisation couplée au second condensateur.

Selon un aspect particulier de l'invention, chaque circuit d'interface d'injection est configuré pour charger ou décharger les premier et deuxième condensateurs à partir du courant d'injection.

Selon un aspect particulier de l'invention, chaque circuit d'interface d'injection comporte une source de courant indépendante pour générer le courant d'injection.

Selon un aspect particulier de l'invention, chaque circuit d'interface d'injection comporte une mémoire RRAM pour générer le courant d'injection.

Selon un aspect particulier de l'invention, le paramètre d'injection est une impédance de charge et chaque circuit d'interface d'injection est configuré pour modifier la valeur d'au moins une impédance de charge de l'oscillateur de façon synchrone avec le signal de synchronisation qui le commande.

Selon un aspect particulier de l'invention, la fréquence de référence est choisie égale à la fréquence d'oscillation propre F0 de l'oscillateur.

Selon un aspect particulier de l'invention, l'oscillateur est un oscillateur nano magnétique.

L'invention a également pour objet un circuit neuronal comprenant un circuit sommateur de phases selon l'invention et un circuit d'activation dans le domaine des phases configuré pour délivrer en sortie un signal d'activation fonction non linéaire du signal de sortie de l'oscillateur.

L'invention a encore pour objet un réseau de neurones à oscillations comprenant une pluralité de circuits neuronaux selon l'invention, dans lequel les signaux propagés dans le réseau sont codés en phase et les poids synaptiques du réseau sont codés en fonction des valeurs des paramètres d'injection des circuits d'interface d'injection.

Selon un aspect particulier de l'invention, le signal de synchronisation de référence est commun au moins à tous les circuits neuronaux réalisant une même couche de neurones.

D'autres caractéristiques et avantages de la présente invention apparaîtront mieux à la lecture de la description qui suit en relation aux dessins annexés suivants.

[Fig. 1] représente un schéma d'un exemple de réseau de neurones artificiels,

[Fig. 2] représente un schéma fonctionnel d'un neurone,

[Fig. 3] représente un schéma électrique d'un circuit oscillateur à relaxation,

[Fig. 4] représente un schéma électrique d'un circuit d'interface d'injection,

[Fig. 5] représente un schéma électrique d'un circuit oscillateur verrouillé par injection selon un premier mode de réalisation de l'invention

[Fig. 6] illustre, sur plusieurs chronogrammes, le fonctionnement du circuit oscillateur verrouillé par injection,

[Fig. 7] représente un schéma électrique d'un circuit neuronal selon l'invention,

[Fig. 8] illustre, sur plusieurs chronogrammes, le fonctionnement du circuit neuronal selon l'invention,

[Fig. 9] illustre sur un diagramme, un premier exemple de fonction d'activation pour réaliser un neurone artificiel,

[Fig. 10] représente un schéma électrique d'un exemple de circuit d'activation apte à réaliser la fonction d'activation de la figure 9,

[Fig. 11] illustre sur un diagramme, un second exemple de fonction d'activation pour réaliser un neurone artificiel,

[Fig.12] représente un schéma électrique d'un exemple de circuit d'activation apte à réaliser la fonction d'activation de la figure 11,

[Fig. 13] représente un schéma électrique d'un circuit oscillateur verrouillé par injection selon un second mode de réalisation de l'invention.

Bien que l'invention soit décrite par la suite principalement pour un mode de réalisation qui concerne les réseaux de neurones artificiels, elle ne se limite pas à cette application et est compatible de tout circuit de calcul nécessitant la réalisation d'une somme pondérée de signaux codés en phase.

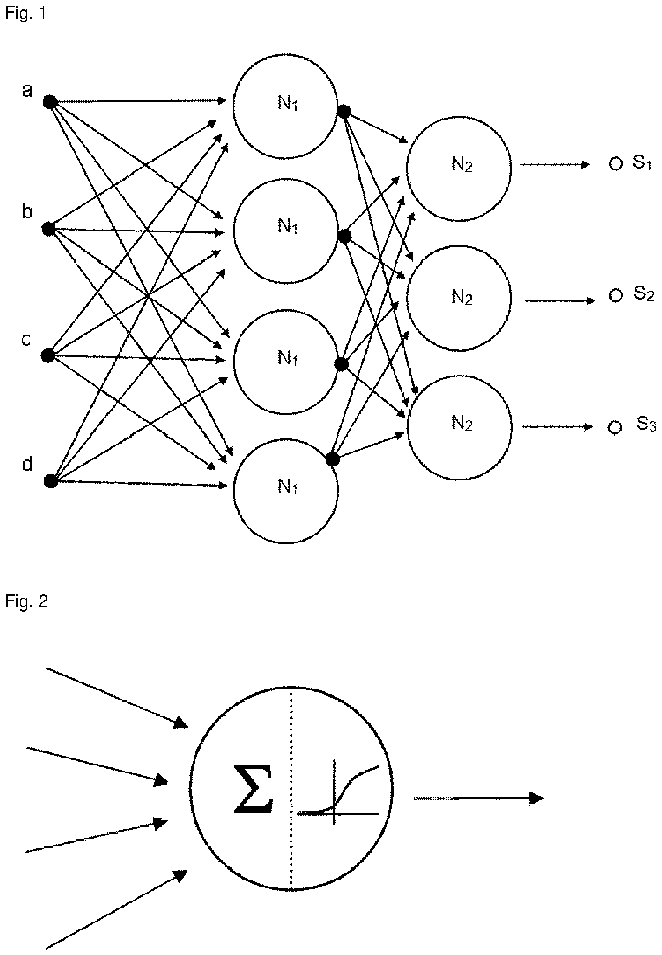

La figure 1 représente un schéma fonctionnel d'un réseau de neurones artificiels comprenant plusieurs couches de neurones, chaque neurone étant connecté à un ou plusieurs neurones de la couche suivante et/ou de la couche précédente. Sur l'exemple de la figure 1, on a représenté uniquement deux couches de neurones mais le nombre de couches est en général plus élevé. De même, le nombre de neurones par couches est aussi en général plus important que sur l'exemple illustré.

Le principe général d'un réseau de neurones est que chaque neurone reçoit plusieurs signaux d'entrée (provenant des entrées du réseau ou des neurones de la couche précédente) et fournit une sortie du même type qui est propagée aux neurones de la couche suivante.

Sur l'exemple de la figure 1, chaque neurone est connecté à tous les neurones de la couche suivante, il s'agit d'un réseau de type « fully connected ». Cependant, il existe aussi des réseaux dits convolutionnels pour lesquels chaque neurone n'est connecté qu'à une partie des neurones de la couche suivante.

La figure 2 schématise le principe de fonctionnement d'un neurone qui réalise une fonction de somme pondérée de ses entrées suivie d'une fonction non linéaire.

Analytiquement, la fonction réalisée par un neurone est donnée par la relation :

$$y = f(\sum[\omega_i . x_i] + b)$$

f est une fonction non linéaire qui représente la fonction d'activation du neurone,

$x_i$ représente les données d'entrée, $\omega_i$ représente les poids synaptiques et b est un biais.

Un objectif de l'invention est de réaliser un calcul de somme pondérée dans le domaine des phases au moyen d'un circuit oscillateur verrouillé par injection.

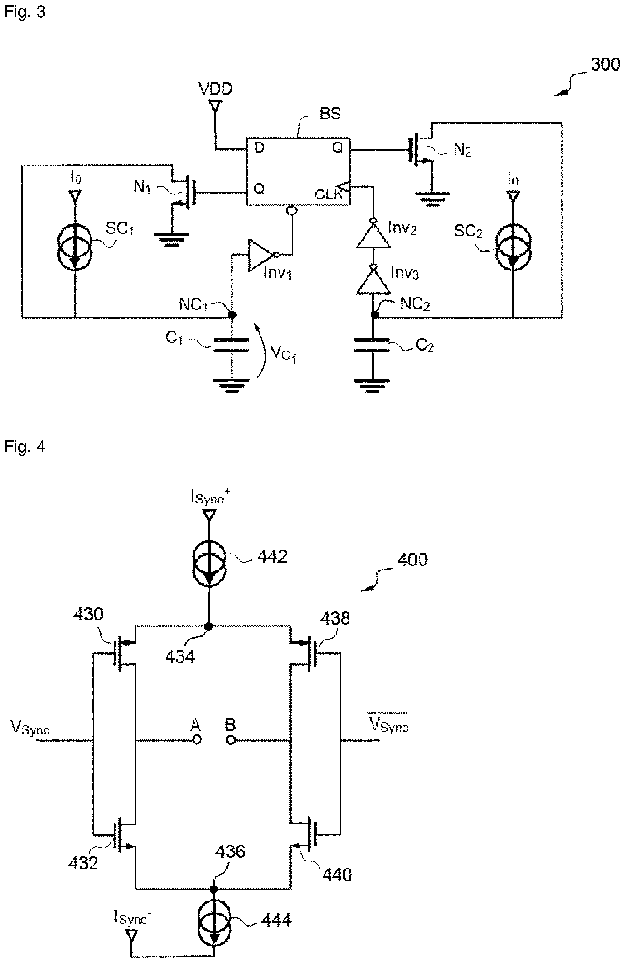

La figure 3 représente un schéma électrique d'un oscillateur à relaxation 300.

L'oscillateur 300 comprend une bascule BS de type D ayant une entrée de donnée D couplée à une tension d'alimentation VDD et ayant deux sorties complémentaires Q et $\overline{Q}$.

La sortie $\overline{Q}$ est couplée à la grille d'un premier transistor N1, par exemple un transistor MOS à canal N, couplé entre la masse et un premier nœud capacitif NC1.

Le nœud NC1 est couplé à la masse par l'intermédiaire d'un condensateur C1 et reçoit un courant provenant d'une source de courant SC.

La sortie Q est couplée à la grille d'un second transistor N2, par exemple un transistor MOS à canal N, couplé entre la masse et un second nœud capacitif NC2.

Le nœud NC2 est couplé à la masse par l'intermédiaire d'un condensateur C2 et reçoit un courant provenant de la même source de courant SC.

Dans une variante de réalisation, la source de courant SC est remplacée par une résistance ou par une mémoire RRAM.

Le nœud NC1 est en outre couplé à une entrée de réinitialisation Rst de la bascule BS par l'intermédiaire d'un inverseur Inv1.

Le nœud NC2 est couplé à une entrée d'horloge de la bascule D par l'intermédiaire de la connexion en série d'une paire d'inverseurs Inv2,Inv3.

L'oscillateur décrit à la figure 3 est dit à relaxation car il fonctionne par contrainte qui est homogène à la tension aux bornes des capacités C1,C2.

Les condensateurs C1,C2 peuvent être dans deux états distincts parmi un état de décharge et un état de charge.

Lorsqu'un condensateur C1,C2 est dans un état de décharge, le transistor qui lui correspond est passant et la capacité est court circuitée entre deux masses.

Lorsqu'un condensateur est dans un état de charge, le transistor qui lui correspond est ouvert et la capacité est chargée par la source de courant SC.

Les grilles des transistors N1,N2 étant reliées aux sorties complémentées de la bascule D, les transistors ne peuvent être que passants ou bloqués et ne peuvent être en même temps dans le même état.

Par exemple, si le condensateur C1 est dans un état de charge, la sortie Q est à la tension VDD et la sortie $\overline{Q}$ est à 0. Dans ces conditions le transistor N1 est bloqué, le transistor N2 est passant et le condensateur C2 est en état de décharge. La tension au nœud NC1 croit, chargée par la source de courant SC, jusqu'à une tension de seuil Vth qui correspond au seuil de commutation des inverseurs. Le passage à la tension de seuil Vth fait commuter la bascule D.

Lors de la commutation de la bascule, la sortie Q passe de VDD à 0, le condensateur C1 passe en état de décharge et le condensateur C2 passe en état de charge. Le cycle se poursuit ainsi et on obtient sur la sortie Q un

$$F_0 = \frac{I_0}{2CV_{th}}$$

signal de type carré à une fréquence propre $F_0$ donnée par la relation suivante : avec C la valeur commune des deux capacités C1,C2 et $I_0$ la valeur du courant de charge injecté aux nœuds capacités NC1,NC2.

Un signal identique mais en opposition de phase apparait sur la sortie $\overline{Q}$.

La figure 4 représente un schéma électrique d'un circuit d'interface d'injection 400.

Le circuit d'interface 400 encore appelé circuit de verrouillage par injection comprend un amplificateur différentiel à transimpédance comprenant des transistors 430 et 432 couplés en série par leurs nœuds de conduction principaux entre des nœuds 434 et 436, et des transistors 438,440 couplés par leurs nœuds de conduction principaux entre les nœuds 434 et 436.

Les transistors 430 et 438 sont par exemple des transistors MOS à canal P et les transistors 432,440 sont par exemple des transistors MOS à canal N.

Les grilles des transistors 430,432 sont couplées de manière à recevoir un signal d'entrée $V_{sync}$ appelé signal de synchronisation qui est un signal carré à une fréquence de référence $F_{sync}$.

Les grilles des transistors 438,440 sont couplées de manière à recevoir un signal d'entrée inverse du signal de synchronisation.

Le nœud 434 est couplé à une première source de courant 442 apte à générer un courant d'injection positif $I_{sync}$. Le nœud 436 est couplé à une seconde source de courant 444 apte à générer un courant d'injection négatif opposé - $I_{sync}$.

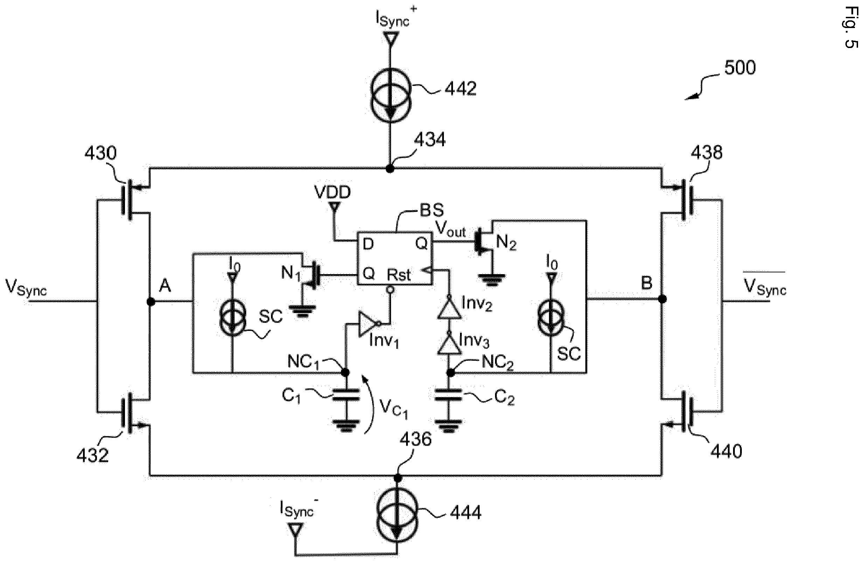

Le circuit d'interface 400 est ensuite couplé à l'oscillateur à relaxation 300 pour réaliser un oscillateur verrouillé par injection 500 tel que décrit à la figure 5.

Le nœud intermédiaire A entre les transistors 430,432 est couplé au nœud NC1. Le nœud intermédiaire B entre les transistors 438,440 est couplé au nœud NC2.

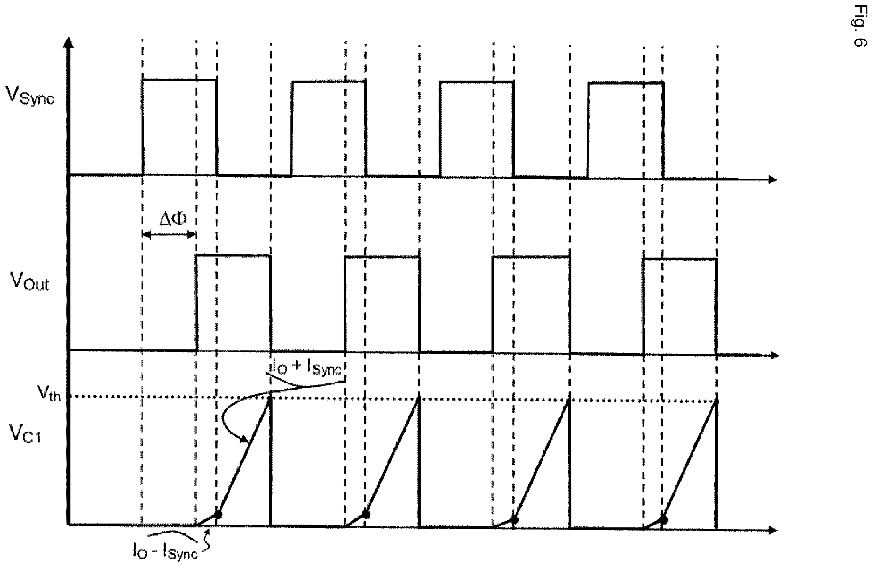

On décrit à présent le fonctionnement de l'oscillateur 500 à l'aide des chronogrammes de la figure 6 qui représentent le signal de synchronisation $V_{sync}$, le signal $V_{out}$ sur la sortie Q de la bascule BS et la tension $V_{C1}$ aux bornes du condensateur C1.

Initialement, on suppose que le signal $V_{out}$ sur la sortie Q de la bascule BS est à l'état bas, le transistor N2 est donc non conducteur et le transistor N1 est conducteur. La tension $V_{C1}$ aux bornes du condensateur C1 est donc tirée vers la masse et le condensateur C2 est chargé par la source de courant SC et par le signal opposé au signal de synchronisation $V_{sync}$.

Lorsque la tension aux bornes du condensateur C2 atteint le seuil de basculement des inverseurs Inv2,Inv3, la bascule BS est réinitialisée et le signal $V_{out}$ sur la sortie Q passe à l'état haut.

Le condensateur C1 est alors chargé par la source de courant SC et aussi par le courant d'injection négatif -$I_{sync}$. Lorsque le signal de synchronisation $V_{sync}$ repasse à l'état bas, le courant d'injection positif $I_{sync}$ est injecté et le condensateur C1 est alors chargé par $I_0 + I_{sync}$, jusqu'à ce que la tension $V_{C1}$ atteigne le seuil de déclenchement de l'inverseur Inv1 qui va réinitialiser la bascule BS et faire passer le signal $V_{out}$ à l'état bas.

En considérant un oscillateur ayant un rapport cyclique de 50% de manière à raisonner sur une demi-période, le courant moyen traversant le condensateur C1 peut être calculé au moyen de la relation suivante :

$$< I > = (1 - \alpha)\left(I_0 - I_{sync}\right) + \alpha\left(I_0 + I_{sync}\right) (1)$$

avec $\alpha = \dfrac{\Delta\phi}{\pi}$ et $\Delta\phi$ le déphasage induit par le mécanisme d'injection entre le signal $V_{out}$ et le signal de synchronisation $V_{sync}$.

Par ailleurs, la fréquence du signal de synchronisation et le courant moyen traversant la capacité C1 sont reliés par la relation suivante : $F_{sync} = \dfrac{<I>}{2CV_{th}}$, C étant la valeur des capacités C1 et C2.

On en déduit que :

$$\alpha = \frac{1}{2} + \frac{1}{2.I_{sync}}\left(< I > -I_0\right)$$

$$\Delta\phi = \frac{\pi CV_{th}}{I_{sync}}\left(F_{sync} - F_0\right) + \frac{\pi}{2} (2)$$

Dans un cas particulier, Si $F_{sync}=F_0$, le déphasage est égal à $\dfrac{\pi}{2}$.

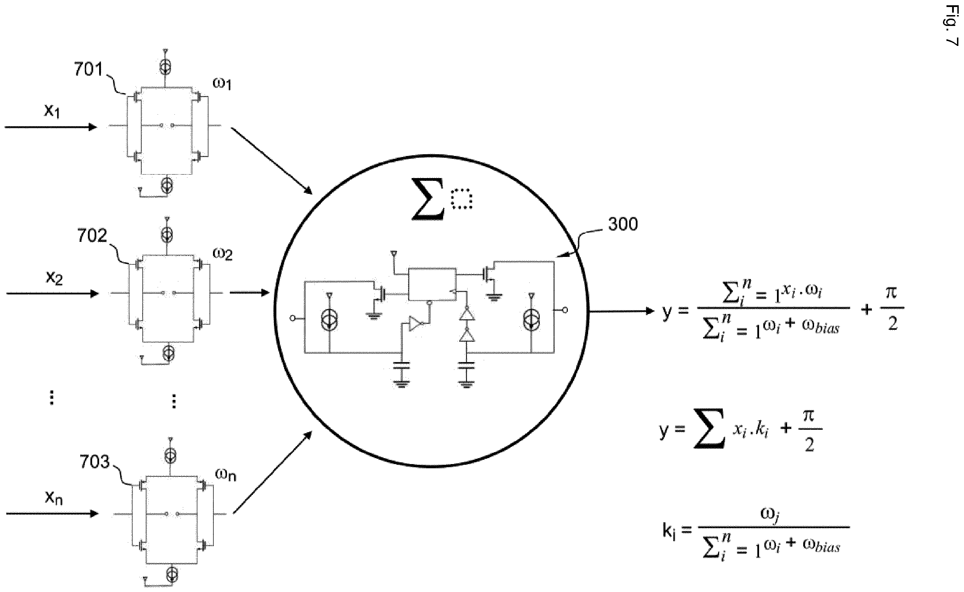

La figure 7 illustre, sur un schéma, l'utilisation d'un oscillateur à relaxation 300 couplé à plusieurs circuits d'interface d'injection 701,702,703 pour réaliser un circuit sommateur de phases selon un mode de réalisation de l'invention.

L'invention consiste à connecter plusieurs circuits d'interface d'injection du type décrit à la figure 4 à un oscillateur à relaxation 300 du type décrit à la figure 3.

Autrement dit, les nœuds intermédiaires A,B de chaque circuit d'interface d'injection 701,702,703 sont connectés respectivement aux nœuds A,B de l'oscillateur 300 représentés sur la figure 7 pour charger les condensateurs C1,C2.

Chaque circuit d'interface d'injection 701,702,703 est commandé par un signal de synchronisation et une source de courant distincts. Les signaux de synchronisation des différents circuits sont tous à la même fréquence $F_{sync}$ qui peut être égale à la fréquence propre de l'oscillateur 300 ou être différente.

Les valeurs des courants d'injection sont contrôlées indépendamment pour chaque circuit d'interface d'injection.

Comme indiqué précédemment, le circuit représenté à la figure 7 peut être utilisé en tant que circuit neuronal pour réaliser un neurone artificiel. Dans ce cas, les signaux d'entrée du neurone $x_1,x_2,x_n$ sont codés par des différences de phases et les poids synaptiques $\omega_1, \omega_2, \omega_n$ correspondent aux valeurs des courants d'injection.

Plus précisément, les signaux d'entrée sont codés par les différences de phases entre les signaux de synchronisation des circuits 701,702,703.

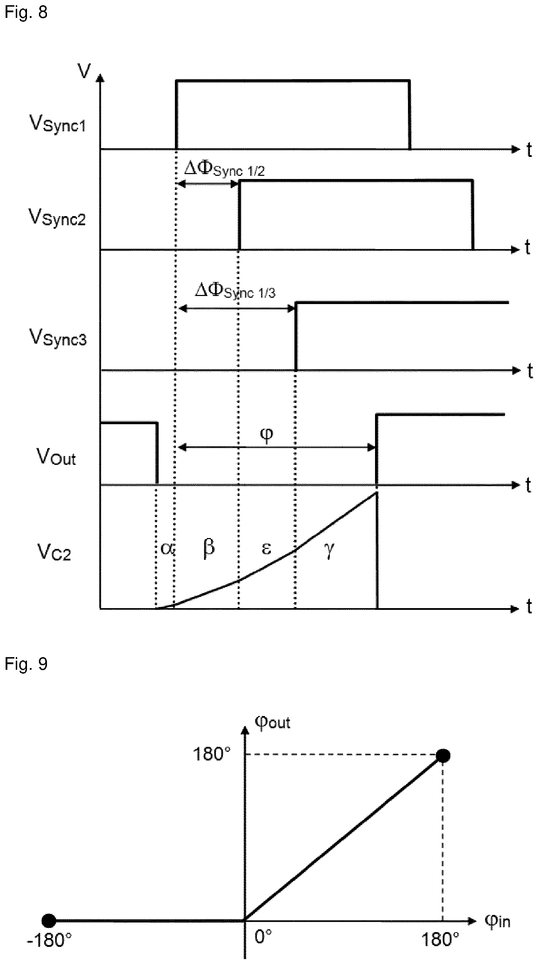

La figure 8 représente un exemple de chronogrammes pour illustrer le fonctionnement du circuit selon l'invention. Sur ces chronogrammes on a représenté, les trois signaux de synchronisation $V_{sync1}$, $V_{sync2}$, $V_{sync3}$, le signal de sortie $V_{out}$ de l'oscillateur et la tension $V_{C2}$ aux bornes du condensateur C2.

L'un des signaux de synchronisation, par exemple le signal $V_{sync1}$ sur l'exemple de la figure 8, est pris comme référence. Les deux autres signaux de synchronisation sont déphasés par rapport au signal de référence. Les signaux d'entrée correspondent à ces deux déphasages $\Delta\Phi_{sync1/2}$ et $\Delta\Phi_{sync1/3}$.

Dans l'exemple de la figure 8, pendant l'intervalle de temps $\alpha$, le condensateur C2 est chargé par le courant $I_0 - I_{sync1} - I_{sync2} - I_{sync3}$. Pendant l'intervalle de temps $\beta$, le condensateur C2 est chargé par le courant $I_0 + I_{sync1} - I_{sync2}$

- $I_{sync3}$. Pendant l'intervalle de temps $\varepsilon$, le condensateur C2 est chargé par le courant $I_0 + I_{sync1} + I_{sync2} - I_{sync3}$. Pendant l'intervalle de temps $\gamma$, le condensateur C2 est chargé par le courant $I_0 + I_{sync1} + I_{sync2} + I_{sync3}$.

En appliquant le même raisonnement développé précédemment pour un oscillateur à une seule injection, on montre que le courant moyen traversant la capacité C1 est donné par la relation :

$$<I> = \alpha\left(I_0 - I_{sync1} - I_{sync2} - I_{sync3}\right) + \beta\left(I_0 + I_{sync1} - I_{sync2} - I_{sync3}\right) + \varepsilon\left(I_0 + I_{sync1} + I_{sync2} - I_{sync3}\right) + \gamma\left(I_0 + I_{sync1} + I_{sync2} + I_{sync3}\right) \quad (3)$$

Avec $1 = \alpha + \beta + \varepsilon + \gamma$

En développant le calcul de façon similaire au cheminement adopté pour passer de la relation (1) à la relation (2), on peut démontrer que le déphasage entre le signal de sortie $V_{out}$ et le signal de référence $V_{sync1}$ s'exprime sous la forme :

$$\varphi = \frac{1}{I_{Sync_1} + I_{Sync_2} + I_{Sync_3}} \cdot \left(C.V_{Th}.\pi.\left(F_{Sync} - F_0\right) + \Delta\Phi_{Sync1/2}.I_{Sync_2} + \Delta\Phi_{Sync1/3}.I_{Sync_3}\right) + \frac{\pi}{2}$$

Et si

$$F_{Sync} = F_0,$$

$$\varphi = \frac{1}{I_{sync1} + I_{sync2} + I_{sync3}} \cdot \left(\Delta\phi_{sync1/2}.I_{sync2} + \Delta\phi_{sync1/3}.I_{sync3}\right) + \frac{\pi}{2} \quad (4)$$

Plus généralement, en utilisant N+1 circuits d'interface d'injection, le signal de sortie de l'oscillateur 300 présente un déphasage par rapport au signal de synchronisation de référence qui est du type :

$$\varphi = \frac{\sum_{i=1}^{n} \varphi_i I_i}{\sum_{i=1}^{n} I_i + I_{ref}} + \frac{\pi}{2}$$

$I_{ref}$ correspond au courant d'injection du circuit d'interface qui sert de référence.

$\varphi_i$ correspond au déphasage entre le signal de synchronisation du circuit d'interface d'injection d'indice i et le signal de synchronisation de référence.

Ainsi, il est possible de réaliser un circuit sommateur de phases pondéré avec cette configuration en choisissant une fréquence de référence $F_{sync}$ égale ou proche de la fréquence fondamentale $F_0$ de l'oscillateur.

Un avantage à fixer $F_{Sync} = F_0$ est que cela permet de simplifier la fonction de transfert du circuit pour arriver à l'équation (4).

Sans sortir du cadre de l'invention, l'oscillateur à relaxation peut être remplacé par tout type d'oscillateur contrôlable par injection de courant ou plus généralement tout type d'oscillateur contrôlable par injection.

La demande de brevet français FR 1872714 décrit par exemple un oscillateur contrôlable par injection à impédance de charge variable qui est compatible de la mise en œuvre de la présente invention.

L'oscillateur à relaxation peut aussi être remplacé par un oscillateur nano magnétique.

Avantageusement, le signal de synchronisation de référence peut être commun à tous les neurones d'une même couche ou à tous les neurones d'un réseau de sorte à avoir la même référence de déphasage pour tous les signaux propagés dans le réseau.

Dans un mode de réalisation, le réseau de neurones conçu à l'aide d'un circuit sommateur de phases selon l'invention comporte un convertisseur ou un encodeur pour convertir les signaux d'entrée dans le domaine des phases. Les signaux d'entrée sont, par exemple, obtenus à partir de capteurs. Le convertisseur est, par exemple, un convertisseur de tension en phase tel que décrit dans la demande de brevet FR3057658 du Demandeur.

Dans une variante de réalisation, les sources de courant de l'oscillateur 300 sont remplacées par des résistances ou par des mémoires RRAM. Dans ce cas, la courbe de charge des condensateurs n'est plus linéaire mais à une forme exponentielle, ce qui induit une relation différente entre les déphasages mais qui correspond toujours à une somme pondérée. Un avantage à l'utilisation de mémoires RRAM est qu'elles sont utilisées également pour mémoriser les valeurs des poids synaptiques.

Comme indiqué en préambule, la fonction réalisée par un neurone est donnée par la relation :

$$y = f\left(\sum[\omega_i . x_i] + b\right)$$

Où f est une fonction non linéaire qui représente la fonction d'activation du neurone.

Un circuit neuronal complet comporte ainsi un circuit sommateur de phases selon l'invention et un circuit d'activation apte à exécuter la fonction d'activation f non linéaire sur la sortie du circuit sommateur de phases.

La figure 9 représente un premier exemple de fonction d'activation, connue sous le terme fonction ReLu qui consiste à :

- si la phase d'entrée $\varphi_{in}$ est négative, appliquer une phase de sortie $\varphi_{out}$ nulle,

- si la phase d'entrée $\varphi_{in}$ est positive, recopier la phase d'entrée sur la phase de sortie $\varphi_{out}$.

Le résultat de la fonction est $2\pi$ périodique et donc la fonction de transfert n'est définie que sur l'intervalle ]-180° : 180°[.

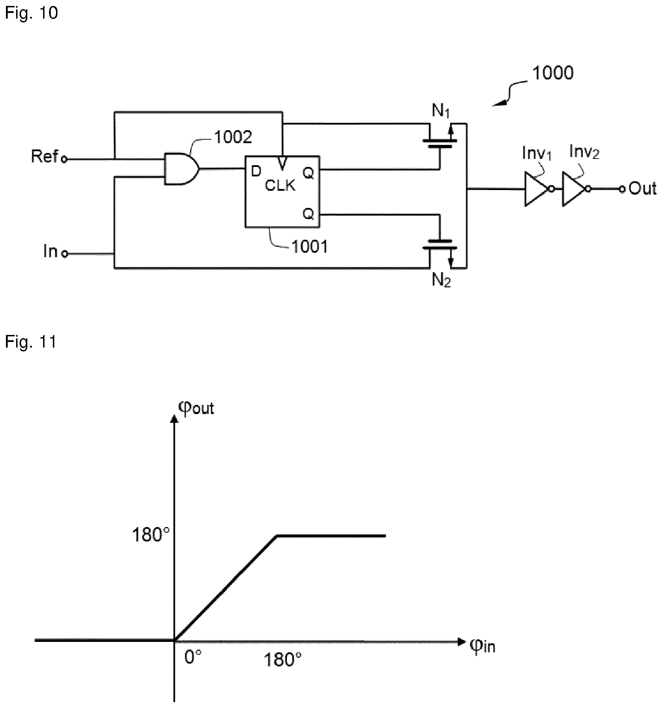

Pour implémenter ce premier exemple de fonction d'activation, le circuit d'activation 1000 de la figure 10 est proposé comme exemple de réalisation.

Il comporte une bascule D 1001, une porte logique ET 1002, deux transistors N1,N2 et deux inverseurs Inv1,Inv2.

Ce circuit comporte une première entrée qui reçoit un signal de référence Ref (représentant la valeur 0) et une seconde entrée In qui reçoit la phase de sortie du circuit sommateur de phases décrit précédemment.

Le circuit d'activation 1000 permet de recopier le signal de référence Ref sur la sortie Out lorsque la seconde entrée In est négative et de recopier la seconde entrée In sur la sortie Out lorsque la seconde entrée In est positive.

Le circuit d'activation 1000 se déclenche sur le front montant du signal de référence Ref. La bascule D 1001, sensible à ce front montant, recopie l'état logique (Ref ET In) de sortie de la porte ET 1002 sur la sortie de donnée Q. Si ce résultat est 1, cela signifie que le front montant du signal de référence se trouve entre le front montant et le front descendant de la seconde entrée In. La phase reçue sur cette seconde entrée In est donc négative et le signal de référence est recopié sur la sortie Out. La sortie Q laisse passer, au travers du transistor N1, le signal de référence vers la sortie Out. Le signal est rehaussé à l'aide de deux inverseurs Inv1,Inv2 afin de pouvoir fournir l'énergie suffisante pour plusieurs sorties.

Dans le cas où la sortie de la porte ET 1002 est égale à 0, alors cela signifie que le front montant du signal Ref est entre le front descendant et le front montant du signal d'entrée In. La phase est donc positive et la seconde entrée In est recopiée sur la sortie.

Sans sortir du cadre de l'invention, d'autres implémentations d'un tel circuit sont envisageables.

La figure 11 représente un second exemple de fonction d'activation qui consiste en une fonction tangente hyperbolique approchée.

Cette fonction consiste à :

- si la phase d'entrée $\varphi_{in}$ est négative, appliquer une phase de sortie $\varphi_{out}$ nulle,

- Si la phase d'entrée $\varphi_{in}$ est positive et inférieure à 180°, recopier la phase d'entrée sur la phase de sortie $\varphi_{out}$,

- Si la phase d'entrée $\varphi_{in}$ est supérieure à 180°, appliquer une phase de sortie constante (par exemple égale à 180°) sur la phase de sortie $\varphi_{out}$.

Ce type de fonction d'activation permet de prendre en compte certains aspects non linéaires intrinsèques à la fonction de transfert du circuit sommateur de phases tel que représenté par l'équation (4). En effet, des non linéarités peuvent exister dans certaines plages de valeur de phases liées aux signes des déphasages.

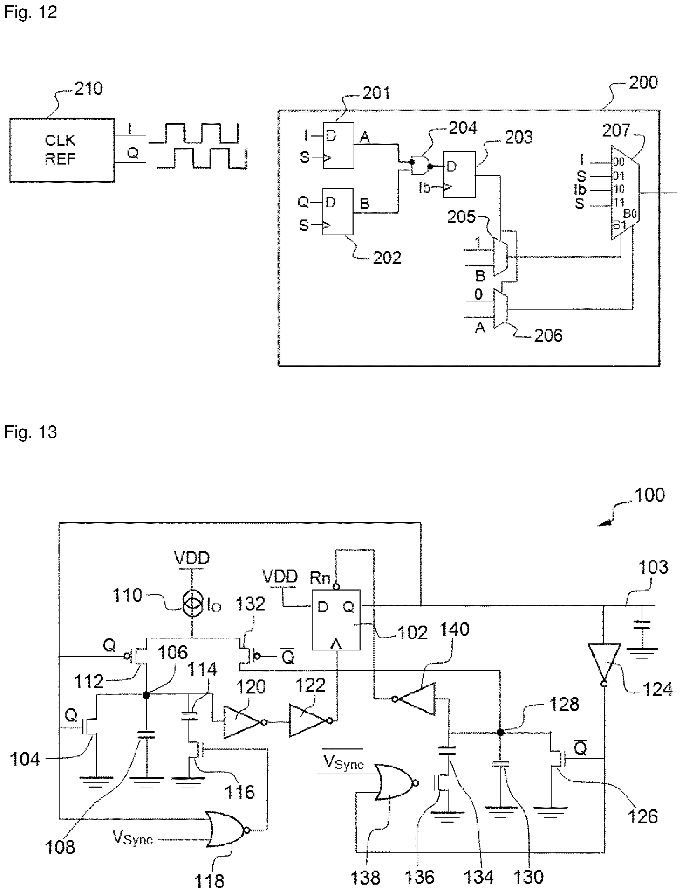

La figure 12 représente un exemple de circuit d'activation 200 apte à réaliser la fonction d'activation décrite à la figure 11.

Le circuit 200 est piloté par une horloge de référence 200 apte à délivrer deux signaux en quadrature I et Q. Le circuit d'activation 200 comporte plusieurs bascules D 201,202,203, une porte logique 204, et plusieurs circuits d'aiguillage 205,206,207.

Le circuit 200 sélectionne une sortie parmi l'entrée S, le signal d'horloge I et le signal complémentaire Ib de la façon suivante :

- Si la phase d'entrée S est nulle, la sortie vaut I,

- Si la phase d'entrée S est comprise entre 0 et 180°, la sortie vaut S,

Si la phase d'entrée est supérieure à 180°, c'est-à-dire si le front montant du signal S arrive après le front descendant du signal I, la sortie vaut Ib.

Les positions respectives du front montant du signal S par rapport aux fronts montants des signaux I et Q sont déterminées par l'état des trois bascules 201,202,203.

Les exemples des figures 9,10,11 et 12 sont donnés à titre purement illustratif et peuvent être remplacés par d'autres implémentations pour réaliser les mêmes fonctions d'activation ou d'autres fonctions.

Bien que l'invention ait été décrite dans le cadre d'une application à la conception de réseaux de neurones artificiels, elle n'est pas limitée à cette seule application mais s'étend à toutes les applications qui nécessitent un circuit sommateur de phases.

Par exemple, le circuit sommateur de phases selon l'invention peut être utilisé pour réaliser un intégrateur de phases ou plus généralement un intégrateur de signaux dans le domaine des phases. Par exemple, un tel intégrateur de phases peut être utilisé pour réaliser un convertisseur analogique numérique sigma delta.

Bien que l'invention ait été décrite en détail sur la base d'un circuit oscillateur verrouillé par injection de courant, elle peut être étendue à tout type de circuit oscillateur verrouillé par injection.

Dans un second mode de réalisation de l'invention, l'oscillateur utilisé est un oscillateur verrouillé par injection à impédance de charge variable tel que décrit dans la demande FR 1872714.

La figure 13 décrit un exemple de circuit oscillateur verrouillé par injection à impédance de charge 100.

L'oscillateur 100 comporte une bascule 102 qui correspond à une bascule D. La bascule 102 comporte une entrée de données D couplée à un potentiel électrique d'alimentation VDD. Une sortie Q de la bascule D 102 est reliée à une sortie 103 de l'oscillateur 100 et est couplée à la grille d'un premier transistor de décharge 104. Une première électrode du premier transistor de décharge 104, correspondant au drain du premier transistor de décharge 104 qui est de type N, est couplée à un premier nœud 106. Une deuxième électrode du premier transistor de décharge 104, correspondant à la source du premier transistor de décharge 104, est couplée à la masse. L'oscillateur 100 comporte également une première impédance de charge 108. Selon un exemple de réalisation, cette première impédance de charge 108 correspond à un premier condensateur, ou plus généralement un premier composant capacitif, de valeur $C_1$. Une première électrode du premier condensateur est couplée au premier nœud 106, et une deuxième électrode du premier condensateur est couplée à la masse.

Un courant de charge $I_0$, correspondant ici à un signal de commande reçu par l'oscillateur 100 (ce signal de commande est symbolisé par une source de courant 110 sur la figure 13) est appliqué sur le premier nœud 106, et donc sur la première impédance de charge 108, à travers un premier transistor d'entrée 112. La sortie Q de la bascule 102 est couplée à la grille du premier transistor d'entrée 112.

L'oscillateur 100 comporte en outre une deuxième impédance de charge 114, ainsi qu'un premier composant de couplage 116 commandé et configuré pour coupler périodiquement la deuxième impédance de charge 114 à la première impédance de charge 108. Selon un exemple de réalisation, cette deuxième impédance de charge 114 correspond à un deuxième condensateur, ou deuxième composant capacitif, de valeur $C_{synchro1}$ et le premier composant de couplage 116 correspond à un premier transistor de couplage 116. Une première électrode du deuxième condensateur est reliée au premier nœud 106. Une deuxième électrode du deuxième condensateur est reliée à une première électrode du premier transistor de couplage 116, et correspond au drain du premier transistor de couplage 116 qui est de type N. Une deuxième électrode du premier transistor de couplage 116, correspondant à la source du premier transistor de couplage 116, est couplée à la masse.

La grille du premier transistor de couplage 116 est couplée à la sortie d'une première porte logique NON-OU 118 comprenant une première entrée couplée à la sortie Q de la bascule 102 et une deuxième entrée sur laquelle un signal de synchronisation $V_{synchro}$ de fréquence $f_{synchro}$ est appliqué. Le signal de synchronisation correspond par exemple à un signal carré dont les valeurs haute et basse sont environ égales à celles du signal délivré sur la sortie Q de la bascule 102. Grâce à la première porte logique NON-OU 118, la deuxième impédance de charge 114 est couplée en parallèle de la première impédance de charge 108 lorsque le signal de synchronisation $V_{synchro}$ et le signal de sortie de la bascule 102 sont tous les deux à l'état bas.

Le premier nœud 106 est également couplé à l'entrée d'un premier inverseur 120, la sortie de ce premier inverseur 120 étant couplée à l'entrée d'un deuxième inverseur 122. La sortie du deuxième inverseur 122 est couplée à l'entrée d'horloge de la bascule 102. Ces inverseurs 120, 122 permettent de redresser le front du signal obtenu sur le premier nœud 106 avant son application sur l'entrée d'horloge de la bascule 102.

La sortie Q de la bascule 102 est également couplée à l'entrée d'un troisième inverseur 124. De manière alternative, le signal obtenu sur la sortie du troisième inverseur 124, correspondant au signal de sortie inversée $\overline{Q}$, pourrait être obtenu sur une sortie inversée de la bascule 102. La sortie du troisième inverseur 124 est couplée à la grille d'un deuxième transistor de décharge 126.

Une première électrode du deuxième transistor de décharge 126, correspondant au drain du deuxième transistor de décharge 126 qui est de type N, est couplée à un deuxième nœud 128. Une deuxième électrode du deuxième transistor de décharge 126, correspondant à la source du deuxième transistor de décharge 126, est couplée à la masse.

L'oscillateur 100 comporte également une troisième impédance de charge 130. Dans ce premier mode de réalisation, cette troisième impédance de charge 130 correspond à un troisième condensateur, ou troisième composant capacitif, de valeur $C_2$. Une première électrode du troisième condensateur est couplée au deuxième nœud 128, et une deuxième électrode du troisième condensateur est couplée à la masse.

Le courant de charge $I_0$ est appliqué sur le deuxième nœud 128, et donc sur la troisième impédance de charge 130, à travers un deuxième transistor d'entrée 132. Le signal de sortie inversée $\overline{Q}$ de la bascule 102 est appliqué sur la grille du deuxième transistor d'entrée 132.

L'oscillateur 100 comporte en outre une quatrième impédance de charge 134, ainsi qu'un deuxième composant de couplage 136 commandé et configuré pour coupler périodiquement la quatrième impédance de charge 134 à la troisième impédance de charge 108. Dans un exemple de réalisation, cette quatrième impédance de charge 134 correspond à un quatrième condensateur, ou quatrième composant capacitif, de valeur $C_{synchro2}$, et le deuxième composant de couplage 136 correspond à un deuxième transistor de couplage.

Les valeurs des condensateurs de l'oscillateur 100 sont ici telles que $C_1 / C_{synchro1} = C_2 / C_{synchro2}$.

Une première électrode du quatrième condensateur est reliée au deuxième nœud 128. Une deuxième électrode du quatrième condensateur est reliée à une première électrode du deuxième transistor de couplage, correspondant au drain du deuxième transistor de couplage qui est de type N. Une deuxième électrode du deuxième transistor de couplage, correspondant à la source du deuxième transistor de couplage, est couplée à la masse.

La grille du deuxième transistor de couplage est couplée à la sortie d'une deuxième porte logique NON-OU 138 comprenant une première entrée couplée à la sortie du troisième inverseur 124 et une deuxième entrée sur laquelle un signal inverse du signal de synchronisation $V_{synchro}$ et de fréquence $F_{synchro}$ est appliqué. Grâce à la deuxième porte logique NON-OU 138, la quatrième impédance de charge 134 est couplée en parallèle de la troisième impédance de charge 130 lorsque le signal inverse de $V_{synchro}$ et le signal de sortie inversée $\overline{Q}$ de la bascule 102 sont tous les deux à l'état bas.

Le deuxième nœud 128 est également couplé à l'entrée d'un quatrième inverseur 140 dont la sortie est couplée à une entrée de réinitialisation de la bascule 102. Cet inverseur 140 permet de redresser le front du signal obtenu sur le deuxième nœud 128 avant son application sur l'entrée de réinitialisation de la bascule 102.

Dans l'oscillateur 100 décrit ci-dessus, les transistors 104, 112, 116, 126, 132 et 136 sont par exemple des transistors MOSFET. D'autres types de transistor peuvent toutefois être utilisés.

Dans l'oscillateur 100 représenté sur la figure 13, le signal de commande correspondant au courant de charge $I_0$ permet de commander directement la fréquence propre de l'oscillateur 100. La valeur de la fréquence propre $f_0$ de l'oscillateur 100 est fonction de l'amplitude de courant de charge $I_0$, et donc de l'amplitude du signal de commande reçu par l'oscillateur 100. Ce signal de commande peut correspondre à un signal de mesure reçu par l'oscillateur 100, ou bien correspondre à un signal obtenu à partir d'un signal de mesure, par exemple un signal délivré en sortie d'un amplificateur à transconductance dont une entrée reçoit le signal de mesure.

Dans cet oscillateur 100, la synchronisation n'est pas réalisée par une injection de courant (ou d'une tension) venant s'ajouter puis se retrancher au signal de commande de l'oscillateur 100 à la fréquence du signal de synchronisation, mais par une modification de la valeur de la ou des impédances de charge (les première et troisième impédances de charge 108, 130 dans l'exemple décrit ci-dessus) de l'oscillateur 100, réalisée à la fréquence du signal de synchronisation $f_{synchro}$. La valeur de cette ou ces impédances de charge est modifiée en couplant et en découplant périodiquement une ou plusieurs autres impédances de charge (les deuxième et quatrième impédances de charge 114, 134 dans l'exemple décrit ci-dessus), en série ou en parallèle (en parallèle dans l'exemple décrit ci-dessus) de cette ou ces impédances de charge. Dans l'exemple décrit ci-dessus, le premier ensemble de charge comprenant les première et deuxième impédances de charges 108, 114 forme donc une capacité dont la valeur alterne entre les valeurs $C_1$ et $C_1 + C_{synchro1}$. De même, le deuxième ensemble de charge comprenant les troisième et quatrième impédances de charges 130, 134 forme donc une capacité dont la valeur alterne entre les valeurs $C_2$ et $C_2 + C_{synchro2}$.

Ainsi, l'oscillateur 100 se verrouille sur la fréquence du signal de synchronisation en ajustant la phase du signal délivré sur la sortie 103, de façon à ce que la valeur de l'impédance de charge moyenne de l'oscillateur 100 soit égale à celle qu'il serait nécessaire pour que l'oscillateur 100 soit en oscillation libre (sans signal de synchronisation appliqué en entrée de l'oscillateur 100) à la fréquence $f_{synchro}$ du signal de synchronisation. Ainsi, le déphasage entre le signal de sortie délivré sur la sortie 103 et le signal de synchronisation est fonction de la différence entre la fréquence propre

$f_0$ de l'oscillateur 100 et la fréquence $f_{synchro}$ du signal de synchronisation $V_{synchro}$.

Lorsque $C_1 = C_2$ et $C_{synchro1} = C_{synchro2}$, le signal obtenu sur la sortie 103 de l'oscillateur 100 a un rapport cyclique égal à 50 % (sur une période de ce signal de sortie, la durée de l'état haut est égale à celle de l'état bas). Le déphasage obtenu entre le signal de synchronisation et le signal délivré sur la sortie 103 de l'oscillateur 100 s'exprime alors par l'équation suivante :

$$\varphi = \pi \left[ \frac{C_1}{C_{synchro1}} \left( \frac{f_0}{f_{synchro}} - 1 \right) \right]$$

Dans le second mode de réalisation de l'invention, l'oscillateur verrouillé par injection de courant décrit à la figure 5 est remplacé par l'oscillateur décrit à la figure 13.

Le circuit neuronal selon l'invention décrit à la figure 7 est alors conçu de façon similaire avec un circuit oscillateur à relaxation et plusieurs circuits d'interface d'injection.

Chaque circuit d'interface d'injection est commandé par un signal de synchronisation différent $V_{synchro}$, ces signaux étant déphasés entre eux et est paramétré par des capacités d'injection $C_{synchro1}, C_{synchro2}$ différentes pour chaque circuit.

En reprenant l'exemple de la figure 7, c'est-à-dire un circuit neuronal comprenant un circuit oscillateur à relaxation et trois circuits d'interface d'injection et en prenant l'hypothèse que C1=C2=C pour le circuit oscillateur à relaxation et $C_{synchro1} = C_{synchro2} = dC_i$ pour chaque circuit d'interface d'injection (i=0,1,2), le signal de sortie de l'oscillateur présente un déphasage par rapport au signal de synchronisation de référence défini par la relation suivante :

$$\varphi = \pi \cdot \frac{C}{dc0+dc1+dc2} * \left[ \frac{F_{sync}}{F_0} - 1 \right] + \frac{C.(C+dc0+dc1+dc2)}{dc0+dc1+dc2} \left[ \varphi_1 \cdot \frac{dc1}{(C+dc2).(C+dc1+dc2)} + \varphi_2 \cdot \frac{dc2}{(C).(C+dc2)} \right]$$

Plus généralement, pour un circuit neuronal comprenant N circuits d'interface d'injection, on peut démontrer que le déphasage s'exprime comme : $\varphi = \sum_{i=0}^{N-1} \omega_i \varphi_i + b$ , avec $\omega_i$ des coefficients de pondération qui dépendent uniquement des valeurs des capacités C et $dC_i$ et b un biais qui dépend des valeurs des capacités C et $dC_i$ ainsi que des valeurs des fréquences $F_{sync}$ et $F_0$, ce biais étant nul si $F_{sync} = F_0$.

$\varphi_i$ correspond au déphasage entre le signal de synchronisation du circuit d'interface d'injection d'indice i et le signal de synchronisation de référence (correspondant à la capacité d'injection $dC_0$).

Des variantes de réalisation du circuit de la figure 13 décrites dans la demande de brevet FR 1872714 peuvent être utilisées pour réaliser des variantes du circuit selon l'invention.

Références

[1] D. Bankman et al. « An always-on 3.8µJ/ 86% CIFAR-10 mixed-signal binary CNN processor with all memory on-chip in 28 nm CMOS », ISSCC 2018

[2] A. Valentian et al. « Fully Integrated Spiking Neural Network with Analog Neurons and RRAM synapses », IEEE IEDM 2019

[3] M.Romera et al. « Vowel recognition with four coupled spin-torque nano-oscillators », Nature vol563, 8 november 2018, p 230

[4] C. Jackson, A. Sharma, J. Bain, J. Weldon L. Pileggi « An RRAM-Based Oscillatory Neural Network », IEEE LASCAS, february 2015

**Revendications**

1. Circuit sommateur de phases à multi-injections comprenant un oscillateur (300) ayant une fréquence d'oscillation propre F0, un circuit d'interface d'injection de référence (701) commandé par un signal de synchronisation de référence à une fréquence de référence et au moins un circuit d'interface d'injection additionnel (702,703) commandé par un signal de synchronisation secondaire à la fréquence de référence, chaque circuit d'interface d'injection (701,702,703) ayant un paramètre d'injection variable, les signaux de synchronisation secondaires étant chacun déphasés par rapport au signal de synchronisation de référence, l'oscillateur (300) étant configuré pour générer un signal de sortie à la fréquence de référence et déphasé par rapport au signal de synchronisation de référence d'un déphasage fonction d'une somme des déphasages respectifs de chaque signal de synchronisation secondaire par rapport au signal de synchronisation de référence, pondérée par les paramètres d'injection.

2. Circuit sommateur de phases selon la revendication 1 comprenant en outre un convertisseur de données en phases pour commander les déphasages respectifs des signaux de synchronisation secondaires par rapport au signal de synchronisation de référence.

3. Circuit sommateur de phases selon l'une quelconque des revendications précédentes dans lequel l'oscillateur est un oscillateur à relaxation (300).

4. Circuit sommateur de phases selon l'une quelconque des revendications précédentes dans lequel le paramètre d'injection est un courant d'injection et chaque circuit d'interface d'injection (701,702,703) est configuré pour injecter, en entrée de l'oscillateur, le courant d'injection de façon synchrone avec le signal de synchronisation qui le commande.

5. Circuit sommateur de phases selon la revendication 4 dans lequel l'oscillateur comprend des premier et deuxième condensateurs (C1,C2) agencés pour être respectivement dans deux états opposés parmi un état de charge et un état de décharge, chaque condensateur basculant de l'état de décharge vers l'état de charge en étant chargé par une source de courant (SC) interne à l'oscillateur.

6. Circuit sommateur de phases selon la revendication 5 dans lequel l'oscillateur (300) comprend des premier et deuxième transistors de charge (N1,N2) et une bascule (BS) ayant une première sortie de donnée couplée à la grille du premier transistor (N2) et une seconde sortie de donnée, complémentée à la première sortie, couplée à la grille du second transistor (N1), la bascule (BS) ayant en outre une entrée de synchronisation couplée au premier condensateur (C1) et une entrée de réinitialisation couplée au second condensateur (C2).

7. Circuit sommateur de phases selon l'une quelconque des revendications 5 ou 6 dans lequel chaque circuit d'interface d'injection (701,702,703) est configuré pour charger ou décharger les premier et deuxième condensateurs (C1,C2) à partir du courant d'injection.

8. Circuit sommateur de phases selon l'une quelconque des revendications 4 à 7 dans lequel chaque circuit d'interface d'injection (400) comporte une source de courant indépendante (442,444) pour générer le courant d'injection.

9. Circuit sommateur de phases selon l'une quelconque des revendications 4 à 7 dans lequel chaque circuit d'interface d'injection comporte une mémoire RRAM pour générer le courant d'injection.

10. Circuit sommateur de phases selon l'une quelconque des revendications 1 à 3 dans lequel le paramètre d'injection est une impédance de charge et chaque circuit d'interface d'injection est configuré pour modifier la valeur d'au moins une impédance de charge de l'oscillateur de façon synchrone avec le signal de synchronisation qui le commande.

11. Circuit sommateur de phases selon l'une quelconque des revendications précédentes dans lequel la fréquence de référence est choisie égale à la fréquence d'oscillation propre $F_0$ de l'oscillateur.

12. Circuit sommateur de phases selon l'une quelconque des revendications 1 ou 2 dans lequel l'oscillateur est un oscillateur nano magnétique.

13. Circuit neuronal comprenant un circuit sommateur de phases selon l'une quelconque des revendications précédentes et un circuit d'activation (1000,200) dans le domaine des phases configuré pour délivrer en sortie un signal d'activation fonction non linéaire du signal de sortie de l'oscillateur.

14. Réseau de neurones à oscillations comprenant une pluralité de circuits neuronaux selon la revendication 13, dans lequel les signaux propagés dans le réseau sont codés en phase et les poids synaptiques du réseau sont codés en fonction des valeurs des paramètres d'injection des circuits d'interface d'injection.

15. Réseau de neurones à oscillations selon la revendication 14 dans lequel le signal de synchronisation de référence est commun au moins à tous les circuits neuronaux réalisant une même couche de neurones.

Fig. 1

Fig. 2

Fig. 3

Fig. 4

Fig. 5

Fig. 6

Fig. 7

EP 4 002 698 A1

$$y = \frac{\sum_{i=1}^{n} x_i \cdot \omega_i}{\sum_{i=1}^{n} \omega_i + \omega_{bias}} + \frac{\pi}{2}$$

$$y = \sum x_i \cdot k_i + \frac{\pi}{2}$$

$$k_i = \frac{\omega_j}{\sum_{i=1}^{n} \omega_i + \omega_{bias}}$$

Fig. 8

Fig. 9

Fig. 10

Fig. 11

Fig. 12

Fig. 13

Europäisches
Patentamt

European
Patent Office

Office européen
des brevets

## RAPPORT DE RECHERCHE EUROPEENNE

Numéro de la demande

EP 21 20 9011

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 317 008 B1 (GABARA THADDEUS J [US]) 13 novembre 2001 (2001-11-13) | 1,2,9, 12-15 | INV. H03L7/24 |
| Y | * colonne 8, ligne 30 - ligne 45; figures 16A,16B * <br> * colonne 8, ligne 46 - ligne 63; figure 17 * | 3-8,10, 11 | G06N3/06 |
| Y | EP 3 312 568 A1 (COMMISSARIAT ENERGIE ATOMIQUE [FR]) 25 avril 2018 (2018-04-25) * alinéa [0034] - alinéa [0045]; figure 4 * | 3-8,10, 11 | |
| A | EP 1 376 869 A1 (ST MICROELECTRONICS SA [FR]) 2 janvier 2004 (2004-01-02) * alinéa [0024] - alinéa [0046]; figure 5 * | 1-15 | |
| A | US 9 673 828 B1 (INNOPHASE INC [US]; INNOPHASE INC [US]) 6 juin 2017 (2017-06-06) * colonne 7, ligne 51 - colonne 8, ligne 44; figure 2 * | 1-15 | |
| A | KORNIIENKO A ET AL: "H[infinity] loop shaping control for distributed PLL network", RESEARCH IN MICROELECTRONICS AND ELECTRONICS, 2009. PRIME 2009. PH.D, IEEE, PISCATAWAY, NJ, USA, 12 juillet 2009 (2009-07-12), pages 336-339, XP031669776, ISBN: 978-1-4244-3733-7 * Section II. PLL Description; figures 1,2 * | 1-15 | |

**DOMAINES TECHNIQUES RECHERCHES (IPC)**

H03L
G06N

Le présent rapport a été établi pour toutes les revendications

| Lieu de la recherche | Date d'achèvement de la recherche | Examinateur |
|---|---|---|
| La Haye | 6 avril 2022 | Aouichi, Mohamed |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 21 20 9011

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-04-2022

| Document brevet cité au rapport de recherche | | Date de publication | Membre(s) de la famille de brevet(s) | | Date de publication |
|---|---|---|---|---|---|
| US 6317008 | B1 | 13-11-2001 | AUCUN | | |
| EP 3312568 | A1 | 25-04-2018 | EP | 3312568 A1 | 25-04-2018 |
| | | | FR | 3057658 A1 | 20-04-2018 |
| | | | US | 2018106695 A1 | 19-04-2018 |
| EP 1376869 | A1 | 02-01-2004 | EP | 1376869 A1 | 02-01-2004 |
| | | | FR | 2841406 A1 | 26-12-2003 |
| | | | JP | 2004048746 A | 12-02-2004 |
| | | | US | 2004057546 A1 | 25-03-2004 |
| US 9673828 | B1 | 06-06-2017 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- FR 1660100
- FR 1872714
- FR 3057658

**Littérature non-brevet citée dans la description**

- **D. BANKMAN et al.** An always-on 3.8μJ/ 86% CIFAR-10 mixed-signal binary CNN processor with all memory on-chip in 28 nm CMOS. *ISSCC,* 2018
- **A. VALENTIAN et al.** Fully Integrated Spiking Neural Network with Analog Neurons and RRAM synapses. *IEEE IEDM,* 2019
- **M.ROMERA et al.** Vowel recognition with four coupled spin-torque nano-oscillators. *Nature,* 08 Novembre 2018, vol. 563, 230
- **C. JACKSON ; A. SHARMA ; J. BAIN ; J. WELDON ; L. PILEGGI.** An RRAM-Based Oscillatory Neural Network. *IEEE LASCAS,* Février 2015